# EUROPEAN PATENT SPECIFICATION

(11) **EP 3 239 681 B1**
(45) Date of publication and mention of the grant of the patent: **04.12.2019**
(21) Application number: 16166845.4
(22) Date of filing: 25.04.2016
(51) Int. Cl.: G01L 9/00, G01L 19/00, B81B 7/02, B81C 1/00, G01N 27/22

(54) **SENSOR DEVICE INCLUDING A PRESSURE SENSOR AND A HUMIDITY SENSOR**
SENSORVORRICHTUNG MIT EINEM DRUCKSENSOR UND EINEM FEUCHTIGKEITSSENSOR
DISPOSITIF DÉTECTEUR COMPRENANT UN CAPTEUR DE PRESSION ET UN CAPTEUR D'HUMIDITÉ

(43) Date of publication of application: 01.11.2017
(73) Proprietor: Sensirion AG, 8712 Stäfa (CH)
(72) Inventor: GRAF, Markus, 8712 Stäfa (CH); HUMMEL, René, 8712 Stäfa (CH); SCHUMM, Johannes, 8712 Stäfa (CH); PLUESS, Marcel, 8712 Stäfa (CH); SU, Wang-Shen, 8712 Stäfa (CH); TANG, Tsung-Lin, 8712 Stäfa (CH); LIN, Chung-Hsien, 8712 Stäfa (CH)
(74) Representative: Detken, Andreas

(56) References cited:
- EP-A1- 2 492 240
- US-A1- 2012 211 845
- US-A1- 2013 328 142
- US-A1- 2014 125 359
- US-A1- 2015 122 041
- US-A1- 2016 023 888

## Description

### TECHNICAL FIELD

The present invention relates to a semiconductor-based sensor device that includes a pressure sensor and a humidity sensor, both sensors being formed on the same semiconductor substrate.

### PRIOR ART

A known type of semiconductor-based humidity sensor comprises a substrate on which a capacitor is formed by interdigitated metallic electrodes. A patch of a moisture-sensitive dielectric is disposed on the electrodes. The moisture-sensitive dielectric absorbs and releases water dependent to the relative environmental humidity, causing changes in the dielectric constant of the moisture-sensitive dielectric and thus changing the electrical capacitance of the capacitor. This change in capacitance is measured by electronic circuitry, which may be integrated on the same substrate. A temperature sensor may also be integrated on the same substrate. The humidity sensor, the temperature sensor and the electronic circuitry thus form a single unit. This enables an accurate determination of relative humidity, without incurring errors due to temperature gradients between the humidity and the temperature sensors. An example of a capacitive semiconductor-based humidity sensor of this type is disclosed, e.g., in US 6,690,569. Such sensors are available, e.g., from Sensirion AG, as the SHT series of sensors.

Also capacitive semiconductor-based pressure sensors are known. Such sensors can comprise a deformable membrane that covers a cavity. A first electrode is disposed in the cavity or is formed by a wall portion of the cavity. The membrane forms or carries a second electrode. Pressure changes cause deformations of the membrane. Such deformations change the electrical capacitance between the two electrodes. These changes are detected by circuitry integrated with the sensor. Various examples of pressure sensors of this type are disclosed, e.g., in US 7,704,774 B2. Also EP 2 492 240 A1, EP 2 871 456 A1 and US 2013/0328142 A1 disclose capacitive pressure sensors that comprise a deformable membrane covering a cavity.

US 2014/0291677 discloses an example of a single chip on which a humidity sensor, a temperature sensor and a pressure sensor are formed in MEMS technology.

US 2014/0125359 A1 discloses a sensor device comprising two humidity sensors and a MEMS pressure sensor formed on a single semiconductor substrate. A passivated silicon substrate carries a first metallization layer, which is etched to form the bottom sensing electrodes of the humidity sensors and of the pressure sensor. Further layers are deposited on top of the first metallization layer.

A sensor device comprising a humidity sensor and a pressure sensor formed on a single semiconductor substrate is also disclosed in US 2016/0023888 A1.

US 2012/0211845 A1 discloses an integrated circuit comprising a substrate carrying a plurality of circuit elements, a metallization stack interconnecting the circuit elements, and a passivation stack covering the metallization stack. A sensor including a sensing material is formed on the passivation stack. The sensor is coupled to a metal portion in the metallization stack by a via extending through the passivation stack.

### SUMMARY OF THE INVENTION

It is an object of the present invention to provide a sensor device comprising at least a humidity sensor and a pressure sensor on a single semiconductor substrate, which sensor device can be easily and reliably manufactured.

This object is achieved by a sensor device according to claim 1.

The present invention provides a sensor device comprising:
a semiconductor substrate, which may optionally have integrated CMOS processing circuitry;
a layer stack disposed on the first semiconductor substrate, the layer stack comprising a sequence of dielectric oxide layers and metallization layers;
a pressure sensor comprising at least a first pressure sensor electrode that is formed by a portion of one of the metallization layers in the layer stack;
a humidity sensor comprising at least a first humidity sensor electrode formed by a portion of the same or a different metallization layer in the layer stack.

If the semiconductor substrate has integrated CMOS processing circuitry, it can be regarded as an intermediate product, which can be obtained by typical CMOS front end of line (FEOL) processing steps. The layer stack is a structure of the type that is typically obtained by CMOS back end of line (BEOL) processing. The dielectric oxide layers can comprise a pre-metal dieletric (PMD) layer to isolate the subsequent metallization layers from the silicon and polysilicon components of the processing circuit, and inter-metal dielectric (IMD) layers to separate the subsequent metallization layers. Additional layers such as etch-stop layers can be provided. If no integrated CMOS processing circuitry is provided, the layer stack can nevertheless be manufactured in a CMOS BEOL process.

According to the invention, the metallization layers are not only employed for their standard purposes, i.e., to create interconnects, power distribution and clock distribution lines etc., but they also define two types of different electrodes, viz., at least one electrode of a pressure sensor and at least one electrode of a humidity sensor. In this manner, it becomes possible to efficiently integrate a pressure sensor and a humidity sensor on the same semiconductor substrate employing commercially available CMOS BEOL processing steps.

Preferably, at least one electrode of the pressure sensor and at least one electrode of the humidity sensor are formed by the same metallization layer or by adjacent metallization layers. This reduces the number of required metallization layers.

The term "pressure sensor" as used herein designates any type of sensor measuring a parameter that is equal to or derived from the pressure of a fluid. In particular, the term designates absolute pressure sensors as well as relative (i.e. differential) pressure sensors; it covers static as well as dynamic pressure sensors. In particular, a pressure sensor may act as a microphone. Typical examples of applications of pressure sensors are e.g. in scientific instrumentation, meteorology, altitude measurement, sound recording, mobile or portable computers and phones etc.

The pressure sensor comprises:
a first recess formed in at least one of the dielectric oxide layers (one of the IMD layers) of the layer stack, wherein the first pressure sensor electrode is disposed in or below the first recess, preferably at its bottom;
a deformable first membrane disposed on top of the first recess so as to close the first recess to form a closed first cavity, the first membrane forming or carrying a second pressure sensor electrode, deformation of the first membrane causing a capacitance between the first pressure sensor electrode and the second pressure sensor electrode to vary; and
a plurality of vias for connecting the first pressure sensor electrode and the second pressure sensor electrode to integrated or external processing circuitry.

For possible embodiments of the pressure sensor and methods for its fabrication, reference is made to US 7,704,774. Specifically, the first membrane or at least part of it can be formed by a semiconductor layer disposed on top of the layer stack.

The humidity sensor comprises:
a second recess formed in at least one of those dielectric oxide layers of the layer stack in which also the first recess is formed, the second recess being laterally separated from the first recess, wherein the first humidity sensor electrode is disposed in or below said second recess.

Both recesses can be readily manufactured in the same processing step by commercially available CMOS processing.

The second recess is preferably entirely separate from the first recess, at least part of at least one dielectric oxide layer extending between the first and the second recess to form a separating structure or wall.

In some embodiments, the humidity sensor can further comprise:
a second humidity sensor electrode disposed in said second recess, said second humidity sensor electrode being interdigitated with said first humidity sensor electrode to form a capacitor;
a moisture-sensitive dielectric disposed in the second recess above and/or between the humidity sensor electrodes; and
a plurality of vias for connecting the first humidity sensor electrode and the second humidity sensor electrode to integrated or external processing circuitry.

The second humidity sensor electrode is preferably interdigitated with said first humidity sensor electrode in the same or different layers of the layer stack. In some embodiments, this can be achieved by each electrode comprising multiple interconnected "fingers", the fingers of one electrode reaching into the gaps between the fingers of the opposing electrode. In other embodiments, the electrodes can be concentrically arranged. Preferably, the first and second humidity sensor electrodes are co-planar, being formed by the same metallization layer. However, they can also be formed in different metallization layers. The first and second sensor electrodes are understood to be "interdigitated" if they have a generally elongated, straight or curved (including circular) shape, if they form a sequence of electrode segments that are arranged side-by-side along their direction of elongation in a projection onto a layer plane, and if the electrode segments of the first and second sensor electrodes alternate in said sequence.

The moisture-sensitive dielectric has a dielectric constant that varies when the dielectric takes up or releases moisture. The moisture-sensitive dielectric is arranged relative to the humidity sensor electrodes in such a manner that it influences the capacitance between these electrodes. Thus a change of dielectric constant of the moisture-sensitive dielectric will cause a change in capacitance between the humidity sensor electrodes, which in turn indicates a change in humidity, and which can be detected by appropriate processing circuitry.

If the first membrane or part of it is formed by a semiconductor layer disposed on top of the layer stack, the semiconductor layer can laterally extend around the humidity sensor, and an access opening can be provided in said semiconductor layer to provide access to the humidity sensor. The access opening preferably has lateral dimensions that are the same as or larger than the lateral dimensions of the second recess, so as to completely expose the second recess and the humidity sensor therein from above.

In other embodiments, the humidity sensor has the same architecture as the pressure sensor in that it comprises:
a second membrane disposed on top of the second recess so as to form a second cavity, the second membrane forming or carrying a second humidity sensor electrode;
at least one access opening that enables gas exchange between a top side and a bottom side of the second membrane; and
a plurality of vias through the layer stack for connecting the first humidity sensor electrode and the second humidity sensor electrode to integrated or external processing circuitry.

In these embodiments, the architecture of the humidity sensor corresponds to the architecture of the pressure sensor. However, in contrast to the pressure sensor, the cavity can freely exchange gas with the environment by virtue of the access opening(s) that connect the top and bottom sides of the membrane. These access openings preferably have dimensions that are sufficiently large to allow for rapid pressure equalization between the two sides of the membrane in the case of pressure changes in the environment. In this manner, pressure changes will hardly deform the membrane and affect the capacitance between the first and second humidity sensor electrodes.

The access opening(s) preferably extend(s) through the second membrane. However, other configurations of the access opening are conceivable, e.g., lateral channels leading to the second cavity, or an access opening extending through the first semiconductor substrate from below.

Both the first membrane and the second membrane can be formed by a single semiconductor layer that is bonded to the layer stack. In other words, the sensor device can comprise a semiconductor layer disposed on top of the layer stack, the semiconductor layer forming at least part of the first membrane and at least part of the second membrane. This enables manufacture of both types of sensors in a single run, employing essentially the same processing steps to simultaneously manufacture both types of sensors.

The second cavity can be free of any moisture-sensitive solid dielectric, such as a moisture-sensitive polymer or ceramic. Surprisingly nevertheless such a sensor is strongly sensitive to humidity changes of the gas within the cavity. Since the cavity does not contain a moisture-sensitive dielectric, the sensor exhibits reduced hysteresis.

In order to rapidly expel excess humidity from the second cavity and to avoid condensation within the second cavity, the sensor device can additionally comprise a heater for heating the second cavity. The heater can be carried by the second membrane, in particular, embedded in said second membrane.

The device can comprise integrated or external processing circuitry. In particular, the processing circuitry can be wholly or partially integrated on the semiconductor substrate. The processing circuitry can be configured to measure a first capacitance between the first and second pressure sensor electrodes and to derive, from said first capacitance, an output signal that is indicative of pressure. The processing circuitry can be further configured to measure a second capacitance between the first and second humidity sensor electrodes and to derive, from said second capacitance, an output signal that is indicative of humidity. To this end, the processing circuity can comprise one or more of the following: an analog signal amplifier; an analog-to-digital converter; a digital signal processor; calibration memory interacting with the digital signal processor; and a digital data interface, in particular, a digital bus interface.

The processing circuitry can be further configured to employ the output signal that is indicative of humidity for deriving the output signal that is indicative of pressure. In other words, the processing circuitry can be configured to carry out humidity compensation when deriving the pressure signal, based on signals from the humidity sensor on the very same semiconductor substrate. Likewise, the processing circuitry may carry out temperature compensation with the aid of a temperature sensor that is also integrated on the same semiconductor substrate. This is of particular importance for a pressure sensor comprising a deformable membrane since such a membrane can be strongly influenced by both temperature and humidity changes.

The present invention also provides a method of manufacturing a sensor device comprising a pressure sensor and a humidity sensor, in particular, of a sensor device as described above. The method comprises, not necessarily in this order:
providing a first semiconductor substrate with integrated CMOS processing circuitry;
forming a layer stack on top of the first semiconductor substrate, the layer stack comprising a sequence of oxide layers and metallization layers;
forming at least one first pressure sensor electrode of the pressure sensor by patterning one of the metallization layers in the layer stack; and
forming at least a first humidity sensor electrode of the humidity sensor by patterning the same metallization layer or a different one of the metallization layers in the layer stack.

The method further comprises:
forming a first recess in at least one of the oxide layers of the layer stack above the first pressure sensor electrode;
bonding a semiconductor layer to the layer stack to form a first membrane on top of the first recess so as to form a first cavity, the first membrane being deformable by pressure; and
forming a plurality of vias through the layer stack for connecting the first pressure sensor electrode and the membrane or a second pressure sensor electrode on the membrane to the CMOS processing circuitry.

In this method, at least one first pressure equalization opening can be provided for enabling gas exchange between the first recess and the environment even after the semiconductor layer has been bonded to the layer stack. Subsequently to bonding the semiconductor layer to the layer stack, annealing is carried out while the first pressure equalization opening is open. The first pressure equalization opening is subsequently closed to hermetically seal the first cavity. In this manner, excessive strains that could lead to breakage of the membrane are avoided during annealing.

The method further comprises forming a second recess in at least one of those oxide layers of the layer stack in which also the first recess is formed, the second recess being laterally separated from the first recess by at least one portion of said at least one oxide layer, the recess being arranged above said first humidity sensor electrode.

The method can further comprise:
providing a second humidity sensor electrode that is interdigitated with said first humidity sensor electrode, the recess being arranged above said first and second humidity sensor electrodes;
forming a plurality of vias through the layer stack for connecting the first humidity sensor electrode and the second humidity sensor electrode to the CMOS processing circuitry; and
selectively disposing a moisture-sensitive dielectric in the second recess above and/or between the humidity sensor electrodes.

The moisture-sensitive dielectric is preferably not applied by gas-phase deposition or by spin-coating, but is applied by a localized method such as inkjet printing or local microdispensing.

During manufacture, the second recess can be covered by the semiconductor layer after the semiconductor layer has been bonded to the layer stack, thereby defining a second cavity. At least one second pressure equalization opening can be provided for enabling gas exchange between the second cavity and the environment even after the semiconductor layer has been bonded to the layer stack. Subsequently, annealing is carried out while the second pressure equalization opening is open. In this manner, membrane damage during annealing is prevented. The semiconductor layer is subsequently etched to provide an access opening to the second recess.

A carrier substrate may finally be mounted on top of the pressure sensor and the humidity sensor, the carrier substrate serving to support the sensor device and to connect the sensor device to the outside world. The carrier substrate can have a through opening that provides access to the second recess. In this case the moisture-sensitive dielectric is preferably disposed in the second recess through the through opening of the carrier substrate.

In other embodiments, the method comprises:
forming a second membrane on top of the second recess so as to form a second cavity, the second membrane being formed by the same semiconductor layer as the one by which the first membrane is formed;
providing at least one access opening to the second cavity to enable gas exchange between the second cavity and an environment; and
forming a plurality of vias through the layer stack for connecting the first humidity sensor electrode and the membrane or a second humidity sensor electrode on the membrane to the CMOS processing circuitry.

Also in such embodiments a carrier substrate may finally be mounted on top of the pressure sensor and the humidity sensor, the carrier substrate serving to support the sensor device and to connect the sensor device to the outside world.

### BRIEF DESCRIPTION OF THE DRAWINGS

Preferred embodiments of the invention are described in the following with reference to the drawings, which are solely provided for the purpose of illustrating the present preferred embodiments of the invention and not for the purpose of limiting the same. In the drawings,
- Fig. 1: shows a schematic sectional view of a sensor device according to a first embodiment of the present invention;
- Figs. 2-8: illustrate various processing steps of a method for manufacturing the sensor device of Fig. 1;
- Fig. 9: shows a schematic sectional view of the sensor device according to the first embodiment with an additional carrier substrate;
- Fig. 10: shows a schematic sectional view of a sensor device according to a second embodiment of the present invention;
- Fig. 11: shows a schematic sectional view of a humidity sensor in a sensor device according to a third embodiment of the present invention;
- Fig. 12: shows a highly schematic diagram illustrating the interaction between a pressure or humidity sensor and associated processing circuitry according to a first variant;
- Fig. 13: shows a highly schematic diagram illustrating the interaction between a pressure or humidity sensor and associated processing circuitry according to a second variant; and
- Fig. 14: shows a highly schematic diagram illustrating the interaction between a pressure or humidity sensor and associated processing circuitry according to a third variant.

### DESCRIPTION OF PREFERRED EMBODIMENTS

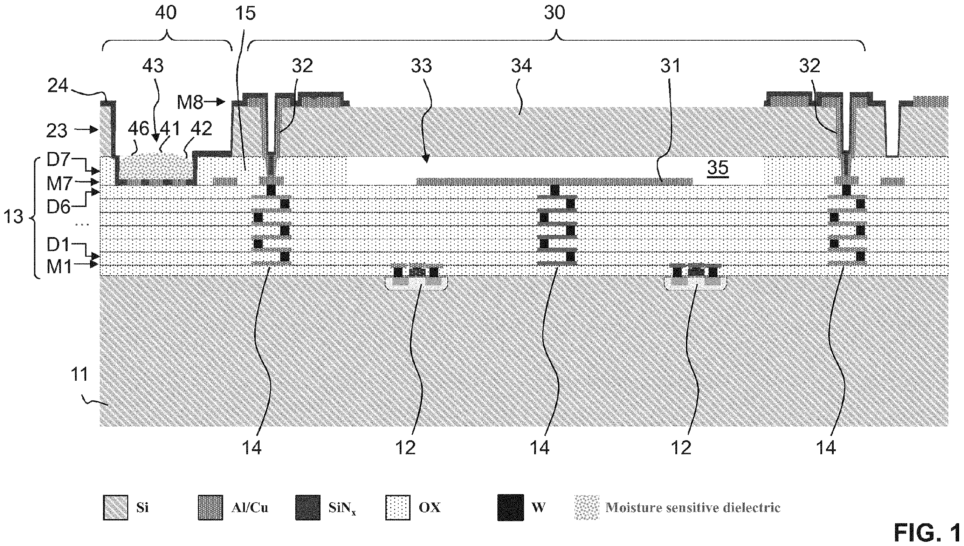

Figure 1 illustrates, in a schematic manner and not to scale, a sensor device according to a first embodiment.

Initially, a first wafer is provided, defining a device plane. The first wafer comprises a semiconductor substrate 11, which carries integrated processing circuitry 12 implemented in CMOS technology. In the example of Fig. 1, only two transistors of the processing circuitry are symbolically illustrated. On top of the processing circuitry 12, a layer stack 13 is formed. The layer stack 13 comprises a plurality of structured metallization layers M1-M7 separated by dielectric silicon oxide layers (intermetal dielectric layers, IMDs) D1-D7. Each metallization layer defines one or more horizontal electrically conductive lines extending in the layer plane. Additional layers such as etch-stop layers (not shown in Fig. 1) may be provided. A plurality of vias 14 extend vertically through the layer stack 13 for interconnecting the conductive lines in the various metallization layers, and for connecting the structures on top of the layer stack, to be explained in more detail below, to these conductive lines. Each via 14 comprises at least one tungsten (chemical symbol W) plug which connects two conductive lines or pads in adjacent metallization layers. In this manner, the various components of the processing circuitry are interconnected and are connected to the structures on top of the layer stack. This setup is per se well known in CMOS technology.

The sensor device comprises a pressure sensor 30 and a humidity sensor 40. First, the setup of pressure sensor 30 will be described. A first recess 33 is formed in the topmost oxide layer D7. Metallization layer M7 is structured to form a first pressure sensor electrode 31 at the bottom of recess 33. First pressure sensor electrode 31 is connected to signal processing circuitry 12 by selected vias 14. First recess 30 is covered by a membrane 34 formed by a silicon device layer 23 that is bonded to the topmost oxide layer D7 of the layer stack 13. Membrane 34 completely spans recess 33 and thus delimits a closed cavity 35, which is hermetically sealed from the environment. In the region where membrane 34 is bonded to topmost oxide layer D7, one or more (in the present example, two) contact vias 32 are provided for electrically connecting membrane 34 to processing circuitry 12. Membrane 34, which is weakly conducting, forms a second pressure sensor electrode. When the pressure in the environment changes (i.e., when the pressure difference between the top side and the bottom side of membrane 34 changes), the distance between first pressure sensor electrode 31 and membrane 34 changes. This causes a change in capacitance between first pressure sensor electrode 31 and membrane 34. Thereby, signal processing circuitry 12 can detect changes of the capacitance between first pressure sensor electrode 31 and membrane 34.

Humidity sensor 40 is located side-by-side with pressure sensor 30 on the same semiconductor substrate 11. It is laterally separated from pressure sensor 30 at least by a portion of topmost oxide layer D7, as well as by a portion of silicon device layer 23, which together can be considered as a separating wall 15. Humidity sensor 40 is formed in a second recess 43 in topmost oxide layer D7, which is accessible from above by a corresponding access opening in silicon device layer 23. On the bottom of second recess 43, two interdigitated humidity sensor electrodes 41, 42 are disposed, which are also formed by the same metallization layer M7 as first pressure sensor electrode 31. These electrodes are connected to signal processing circuitry 12 by selected vias (not shown in Fig. 1). Humidity sensor electrodes 41, 42 are protected by a protective silicon nitride layer 24. On top of this layer, recess 43 is filled with a moisture-sensitive dielectric 46. The moisture-sensitive dielectric 46 extends above and partially between humidity sensor electrodes 41, 42 and thereby influences the capacitance between these electrodes. A change in humidity will cause a change of the dielectric properties of moisture-sensitive dielectric 46 and will thus cause a change in capacitance between humidity sensor electrodes 41, 42. This change in capacitance can be detected by signal-processing circuitry 12.

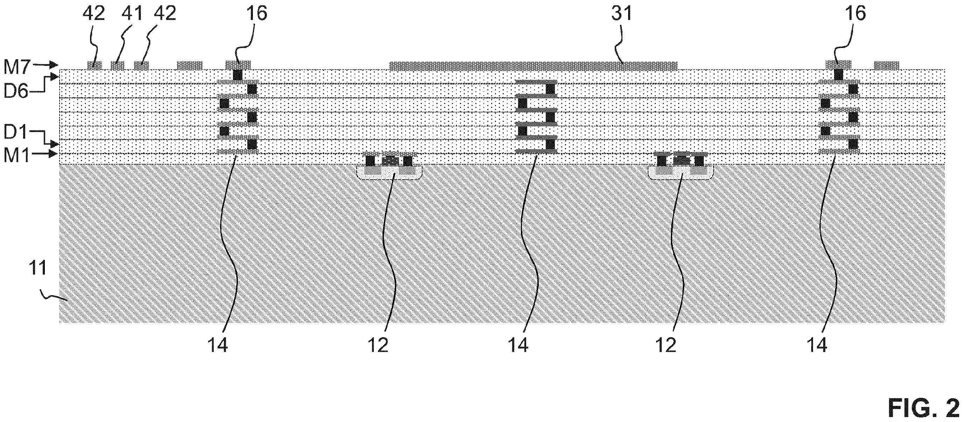

In the following, fabrication of the sensor device will be described with reference to Figs. 2-8.

As illustrated in Fig. 2, initially a semiconductor substrate 11 (in the present example, a silicon substrate) having integrated CMOS circuitry 12 on its top surface is provided. On top of the CMOS circuitry, metallization layers M1-M7 and dielectric oxide layers D1-D6 are deposited by well-known CMOS processing techniques, each metallization layer being disposed between two adjacent dielectric oxide layers. A plurality of vias 14 are formed in the process by etching openings into the dielectric oxide layers and filling these with tungsten. Fig. 2 shows the state after metallization layer M7 has been deposited onto dielectric oxide layer D6 and has been patterned. Dielectric oxide layer D6 has a thickness of approximately 1 micrometer, as it is common in the art. Chemical-mechanical polishing (CMP) has been carried out before deposition of metallization layer M7. Metallization layer M7 has a thickness of approximately 1 micrometer, as it is common in the art.

Each metallization layer can comprise a metal or alloy as usually employed in CMOS processing, such as aluminum (Al) or alloys comprising aluminum and copper (AlCu). It may be supplemented with thin layers of titanium (Ti) and/or titanium nitride (TiN) below and on top of the metallization layer, forming a TiN/AlCu/TiN or TiN/AlCu/Ti structure, as it is well known per se. The metallization layer is structured by dry or wet etching to form first pressure sensor electrode 31, first and second humidity sensor electrodes 41, 42 as well as conductive lines and contact pads 16 for connection to vias 14.

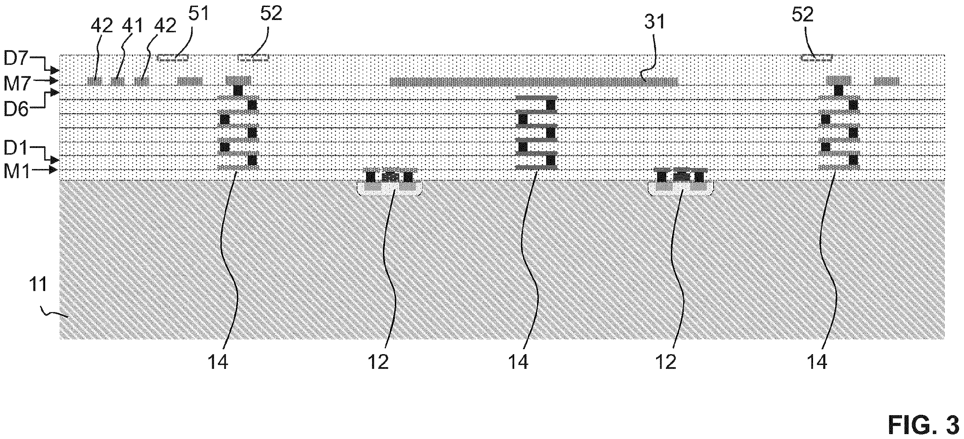

As illustrated in Fig. 3, subsequently a seventh dielectric oxide layer D7 is deposited and treated by CMP to facilitate subsequent fusion bonding. The resulting layer D7 has a thickness of approximately 2 micrometers. Shallow trenches 51, 52 of approximately 0.1 micrometer depth are etched into layer D7 for enabling gas exchange with the cavities that will be manufactured in subsequent fabrication steps.

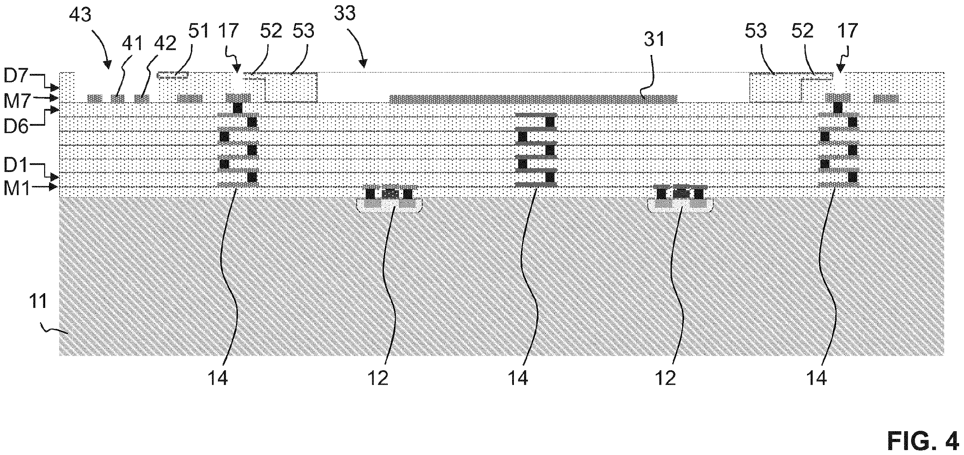

As illustrated in Fig. 4, recess 33 of the pressure sensor and recess 43 of the humidity sensor are etched from layer D7. This can be done in one single common etching process or in separate processes. In addition, contact openings 17 are etched to provide access to contact pads 16 in layer M7, and lateral channels 53 are etched, each of these lateral channels extending from recess 33 to one of shallow trenches 52 so as to provide a gas-permeable connection between recess 33 and the respective shallow trench 52.

In order to ensure a well-defined etching depth, an etch-stop layer (not shown) can be present below layer M7. This may be particularly advantageous in the region of recess 43 of the humidity sensor. In particular, the etch-stop layer may comprise a metal structure in a layer below layer M7, the metal structure being arranged below the gaps between humidity sensor electrodes 41, 42, as described in more detail in EP 2 565 635 A1.

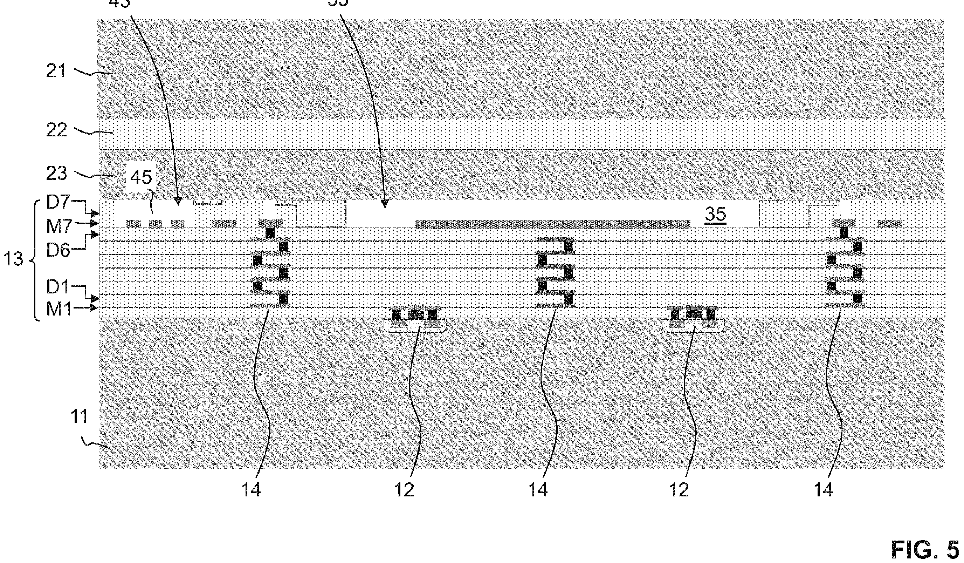

As illustrated in Fig. 5, a second wafer comprising a silicon substrate 21, a buried oxide (BOX) layer 22 and a silicon device layer 23 is fusion-bonded head-on to the first wafer, such that silicon device layer 23 is directly bonded to dielectric oxide layer D7. Thereby recesses 33 and 43 are closed by silicon device layer 23, and closed cavities 35, 45 are formed.

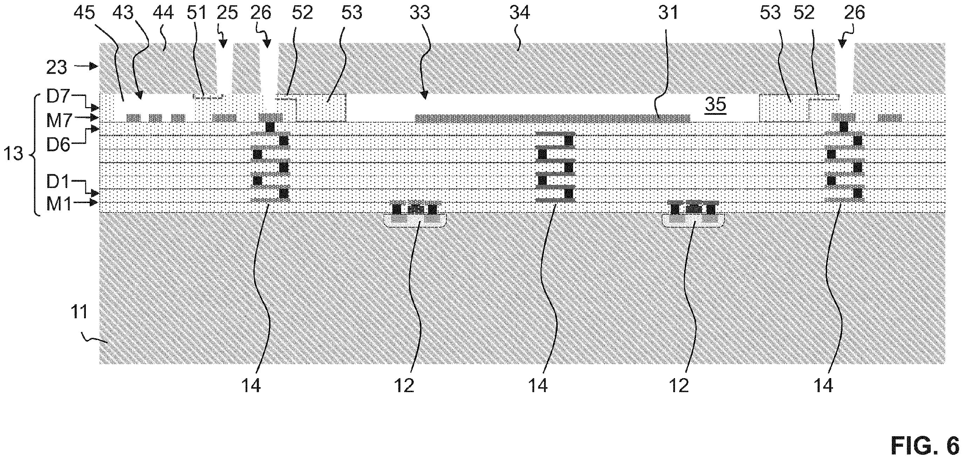

As illustrated in Fig. 6, silicon substrate 21 is removed by grinding and/or dry etching, and BOX layer 22 is removed by dry and/or wet etching. The remaining silicon device layer 23 has a thickness of approximately 5 micrometers. In the region of cavity 35, device layer 23 forms membrane 34 which spans recess 33. Likewise, in the region of cavity 45, device layer 23 forms membrane 44 which spans recess 43.

Pressure equalization openings 25, 26 are etched into device layer 23. Opening 25 serves to establish a gas-permeable connection between cavity 45 and the environment. Openings 26 serve a dual purpose. On the one hand, they establish a gas-permeable connection between cavity 35 and the environment (via trenches 52 and channels 53). On the other hand, they will later house contact vias 32 (Fig. 1) for connecting membrane 34 to the processing circuitry 12. The gas-permeable connections serve to prevent breakage of membranes 34, 44 during subsequent annealing of the bond between dielectric oxide layer D7 and device layer 21. In addition, they allow evacuation of pressure sensor cavity 35 before said cavity is finally sealed.

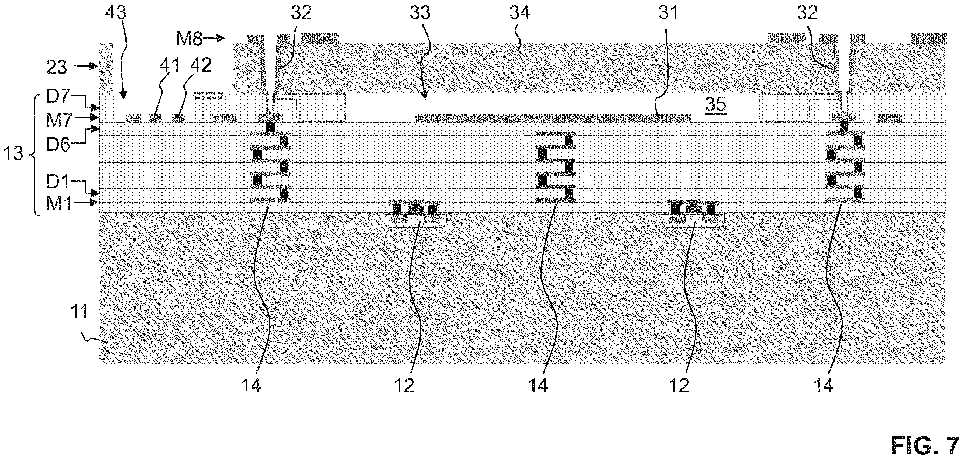

As illustrated in Fig. 7, after bond annealing, pressure sensor cavity 35 is evacuated, and metallization layer M8 is deposited. Layer M8 extends into pressure equalization openings 25, 26 to form contact vias 32 and to close the gas-permeable connections to pressure sensor cavity 35. Pressure sensor cavity 35 is now hermetically sealed. Subsequently, layer M8 is patterned in the manner shown in Fig. 7, and membrane 44 is etched away from device layer 23 to provide an access opening which allows free access to recess 43 and electrodes 41, 42 from above, the access opening having larger lateral dimensions than recess 43.

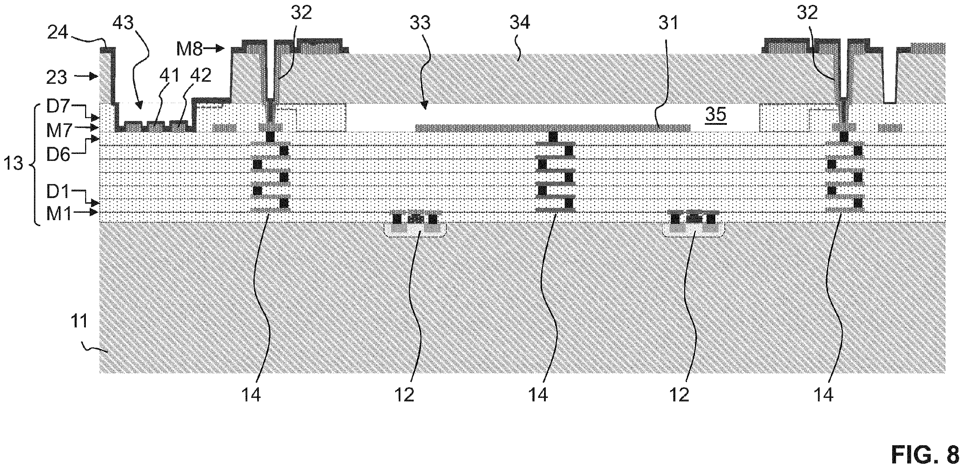

As illustrated in Fig. 8, a protective layer 24 of approximately 0.5 micrometers silicon nitride (SiNₓ) is deposited onto the device of Fig. 7. Protective layer 24 is subsequently patterned by etching to expose membrane 34 of pressure sensor 30. As a result, neither silicon oxide nor silicon nitride layers remain on membrane 34. Protective layer 24 primarily acts to protect humidity sensor electrodes 41, 42 and contact vias 32 from oxidation and increases the lifetime and reliability of the sensor device. For more details concerning the protective layer, reference is made to US 6,690,569.

Finally, moisture-sensitive dielectric 46 is locally applied into recess 43. The dielectric can be, e.g., a moisture-sensitive polymer. Moisture-sensitive dielectric 46 absorbs humidity from the environment, which causes a change in its dielectric constant. It can be applied by any method that allows localized application, e.g., by micro-dispensing techniques or by ink-jet printing. Since the moisture-sensitive dielectric 46 is added only after all CMOS processing steps have been completed, a broad choice of materials can be employed, as these materials do not need to be compatible with CMOS processing.

In simplified modifications, no integrated processing circuitry 12 is provided on substrate 11, and the sensor electrodes are directly connected to the outside world through the metallization layers and contact vias.

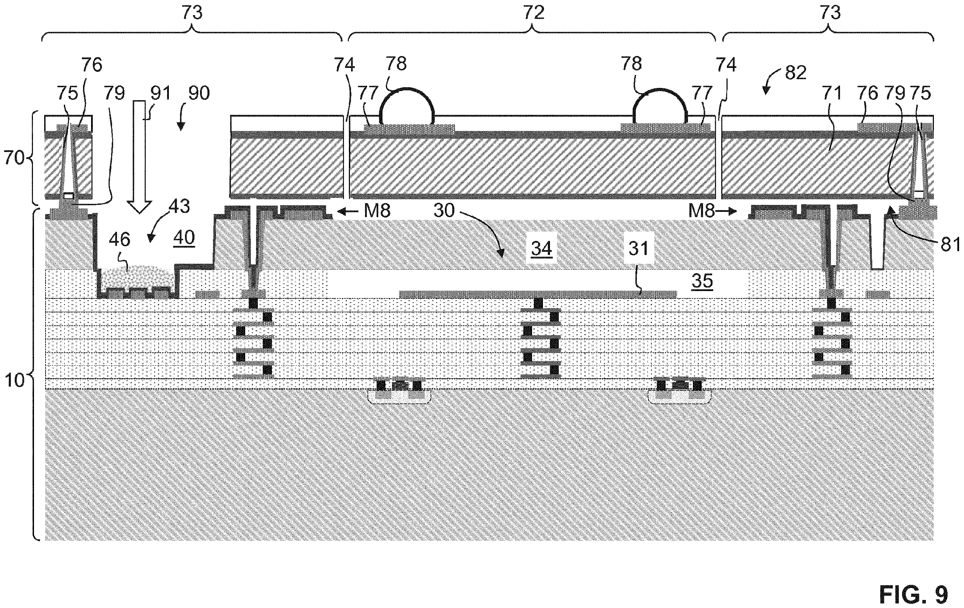

Fig. 9 illustrates a further modification of the sensor device according to the first embodiment. This modification comprises a sensor sub-assembly 10, which is similar to the sensor device of the first embodiment as illustrated in Fig. 1, the sensor sub-assembly 10 being mounted head-on to a carrier 70. The carrier 70 is configured in a generally similar manner as the structure that is called the "first substrate" in EP 2 871 456 A1.

The carrier 70 comprises a carrier substrate 71, e.g. a semiconductor substrate or a glass substrate, with a bottom side 81 facing the sensor sub-assembly 10, and with a top side 12 facing away from the sensor sub-assembly. One or more layers such as oxide layers, polysilicon layers and metallization layers can be disposed on either side of the carrier substrate 71.

When viewed in the device plane, the carrier 70 is generally divided into a central support portion 72 and a contact portion 73, which surrounds the central support portion 72. The central support portion 72 serves for connecting the carrier 70 to external circuitry, while the surrounding contact portion 73 serves for connecting the carrier 70 to the sensor sub-assembly 10. The support portion 72 and the contact portion 73 are laterally separated by a cut which defines an elongated gas-exchange opening 74 through the carrier 70. The cut does not fully surround the support portion 72, thereby leaving a relatively narrow bridge (not shown in Fig. 9) forming a suspension element between the support portion 72 and the contact portion 73. Other types of suspensions elements may be employed. Since the support portion 72 and the carrier portion 73 are connected only via a relatively narrow bridge or another type of suspension element, the sensor device is mechanically decoupled from strains that may affect the support portion 72 when it is mounted to external circuitry.

In the contact portion 73, the carrier 70 comprises contact vias 75 reaching vertically through the substrate 71. The contact vias 75 provide for an electrical connection from the bottom side 81 of the substrate 71 to its top side 82. Each contact via 75 is manufactured in a generally known manner by etching a hole into the substrate 71, by applying an oxide to the hole, and by applying conducting material to the oxide. At the top side 82 of the substrate 71, the contact vias 75 are electrically connected to contact pads 76 residing on an oxide layer applied to the substrate 71. These contact pads 76 are electrically connected, via the bridge, to contact pads 77 on the support portion 72. The contact pads 77 in turn serve as supports for solder balls 78 or other contact means for electrically connecting the carrier 70 to external circuitry. As an alternative to the vias 75 and the solder balls 78, other means of interconnecting the sensor device to external circuitry may be provided, e.g., wire bonds, bond pads or conducting structures that lead from the bottom side 81 of the substrate 71 along its sides to the top side 82. The electrical connection to external circuitry may also be implemented via one or more of a Land Grid Array, a Pin Grid Array, or a leadframe.

The bottom side 81 of the carrier 70 is attached to the top side of the sensor sub-assembly 10. The attachment may include bonding or other fusion techniques. In the present example, spacer elements 79 are provided between metallization layer M8 of the sensor sub-assembly and the carrier 70. The spacer elements 79 may have different functions: On the one hand, the spacer elements 79 provide for a gap between the deformable membrane 34 and the carrier 70, through which the pressure medium is supplied to the membrane 34. On the other hand, some of the spacer elements 79, but not necessarily all may be electrically conductive for electrically connecting the sensor sub-assembly to the contact vias 75. One or more of the spacer elements 79 may be configured to provide added mechanical protection to the sensor sub-assembly and specifically to the membrane 34. For this purpose, one or more of the spacer elements may be arranged in form of a closed or open ring that fully or partially surrounds the membrane 34.

The signals provided by the integrated processing circuit 12 hence may be transferred via one or more of the vias 14 and via one or more of the contact vias 32 to one or more of the spacer elements 79. From there, the signals may be conducted through the contact vias 75 of the carrier 70 and the contact pads 76, 77 to the solder balls 78.

The carrier 70 has a through hole 90, which provides open access to the recess 43 in which the humidity sensor 40 is formed. When manufacturing the sensor device, is preferred that the moisture-sensitive dielectric 46 is applied to the recess through the through-hole 90 (as symbolized by arrow 91), after the carrier 70 has been mounted to the sensor sub-assembly.

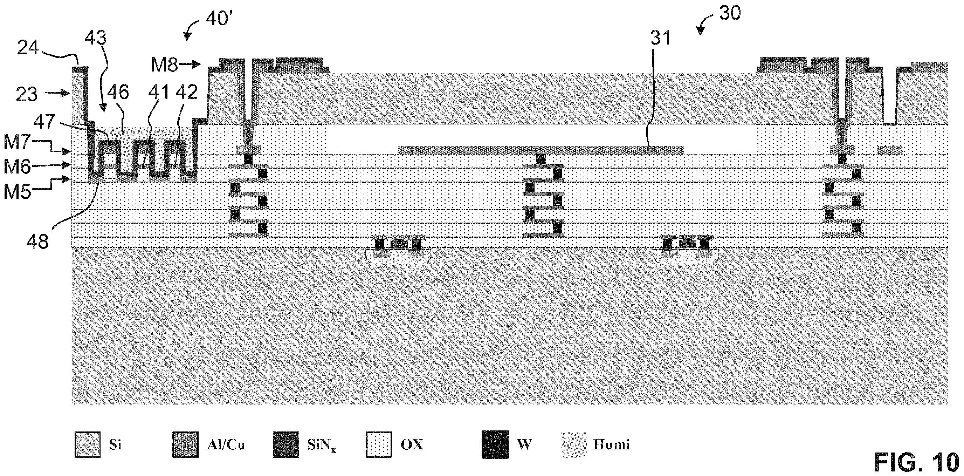

Figure 10 illustrates, in a schematic manner and not to scale, a sensor device according to a second embodiment. Like components carry the same reference signs as in the first embodiment. The pressure sensor 30 of the second embodiment is the same as in the first embodiment. The humidity sensor 40' of the second embodiment, however, differs from the humidity sensor 40 of the first embodiment in that the humidity sensor electrodes 41, 42 are formed in a different metallization layer than the first pressure sensor electrode 31, and in that additional metallization layers are employed to form shielding electrodes 47, 48.

In particular, humidity sensor electrodes 41, 42 are formed in metallization layer M6, whereas first pressure sensor electrode 31 is formed in adjacent metallization layer M7. Above each humidity sensor electrode 41, 42, an upper shielding electrode 47 is disposed in metallization layer M7. Below the gaps between humidity sensor electrodes 41, 42, a lower shielding electrode 48 is disposed in metallization layer M5. The lower shielding electrodes 48 also act as an etch stop when recesses are etched into dielectric oxide layers D5, D6 and D7.

The shielding electrodes 47, 48 shape the electric field between humidity sensor electrodes 41, 42 and shield the humidity sensor electrodes 41, 42 from external disturbances. For details of metal structures of the type of shielding electrodes 47, 48, reference is made to EP 2 565 635 A1 and DE 20 2013 105 955 U1.

In a modification, the humidity sensor electrodes 41, 42 may be formed in different metallization layers, e.g., in layers M6 and M7.

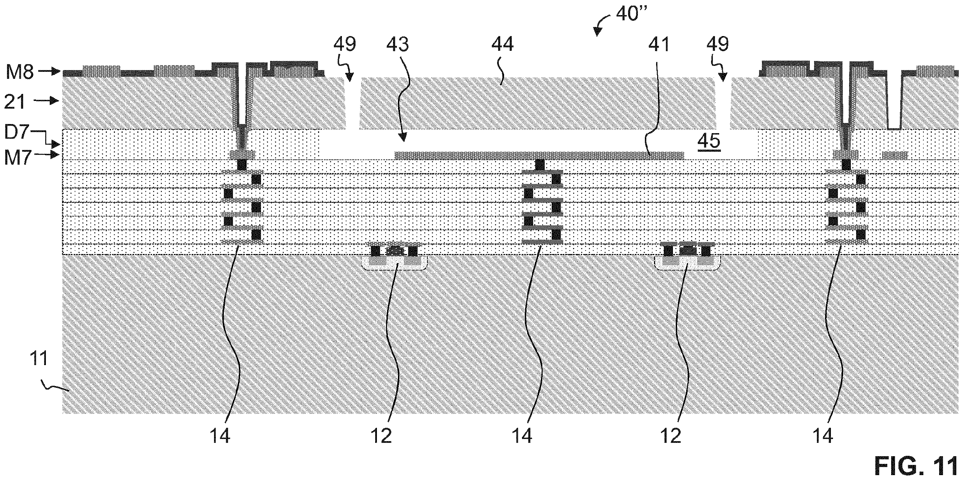

Figure 11 illustrates, again in a schematic manner and not to scale, the humidity sensor 40" of a sensor device according to a third embodiment. In this embodiment, the pressure sensor (not shown in Fig. 10) is the same as in the first and second embodiments. The humidity sensor 40" has the same architecture as the pressure sensor 30 of the first and second embodiments. In particular, it comprises a recess 43 in the topmost oxide layer D7. A first humidity sensor electrode 41 is disposed at the bottom of recess 43; this electrode is formed by metallization layer M7. Selected vias 14 connect first humidity sensor electrode 41 to signal processing circuitry 12. A membrane 44 formed by silicon device layer 23 is bonded to topmost oxide layer D7 and spans recess 43, thus defining a cavity 45. Access opening 49 are etched into membrane 44 to enable gas exchange between cavity 45 and the environment. In the region where membrane 44 is bonded to topmost oxide layer D7, one or more (in the present example, two) contact vias are provided for electrically connecting membrane 44 to processing circuitry 12. Membrane 44, which is weakly conducting, forms a second humidity sensor electrode. A change of humidity in cavity 45 causes a change in capacitance between first humidity sensor electrode 41 and membrane 44. Thereby, signal processing circuitry 12 can detect changes of the capacitance between first and second humidity sensor electrode 41 and membrane 44.

Access openings 49 enable rapid gas exchange between cavity 45 and the environment, i.e., between the top and bottom sides of membrane 44. In this manner, membrane 44 is hardly affected by gas pressure changes in the environment, and consequently the electrical capacitance between first humidity sensor electrode 41 and membrane 44 is largely insensitive to gas pressure.

In preferred embodiments, the cavity does not contain any moisture-sensitive solid dielectric material, i.e., it is filled only with the gas that is exchanged with the environment through the access openings 49. Since no moisture-sensitive dielectric is employed, response times may be improved as compared to humidity sensors of the type employed in the first and second embodiments. In further embodiments, however, it is conceivable to provide a moisture-sensitive dielectric inside cavity 45.

In order to rapidly expel excess moisture from cavity 45 and to prevent condensation of liquid water inside cavity 45, a heater element (not shown) can be provided inside cavity 45.

The sensor device of the second and third embodiments can be provided with a carrier 70 similar to the one illustrated in Fig. 9.

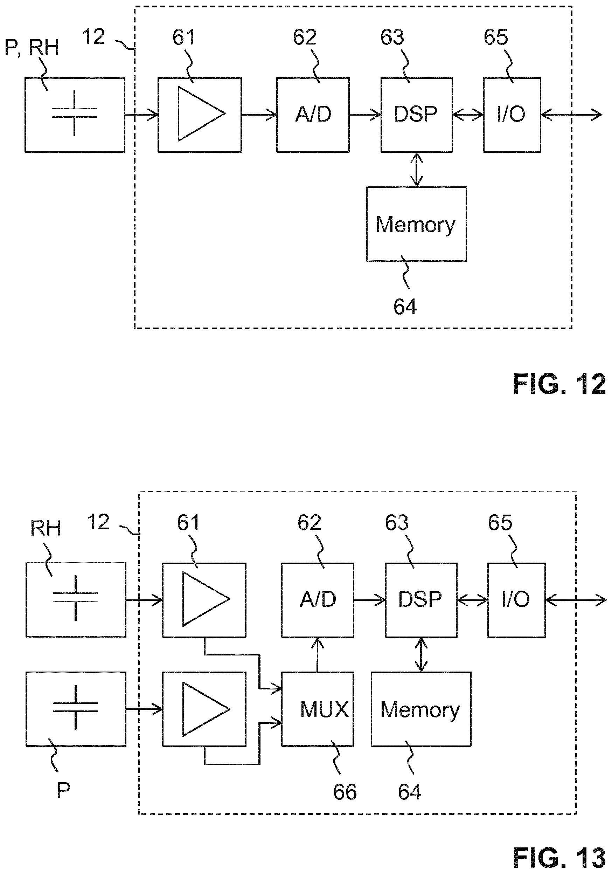

Figure 12 illustrates, in a highly schematic manner, a functional diagram of processing circuitry for the pressure sensor 30 (indicated by reference symbol P) or for the humidity sensor 40, 40', 40" (indicated by reference symbol RH) according to a first variant. The processing circuitry may be integrated on substrate 11, or it may be provided separately. The capacitance between the pressure or humidity sensor electrodes is determined, and the corresponding signal is electronically amplified, by a signal amplifier 61. The output of signal amplifier 61 is digitized by analog-to-digital (A/D) converter 62. The digitized signals are further processed by digital signal processor (DSP) 63, which interacts with a non-volatile memory 64, e.g., a flash memory, in which calibration values for the respective sensor are stored. At its output, the DSP provides a digitized output value representative of the environmental pressure or of the humidity of the gaseous medium, respectively. This output value is made available to the outside world by a digital data interface (I/O interface) 65, e.g., a digital bus interface.

Digital signal processor 63 may, in addition, receive temperature data from a temperature sensor (not shown) to directly determine dew point or, equivalently, relative humidity.

Separate arrangements of a signal amplifier 61, A/D converter 62, DSP 63 and I/O interface 65 each may be provided for the pressure sensor and for the humidity sensor, respectively.

The signals representative of humidity and temperature may further be employed for correcting for the influences of temperature and humidity on the membrane 34, so as to obtain a corrected pressure reading. This correction may be carried out by the DSP that is associated with the pressure sensor 30, which in this case receives the humidity signal from the DSP that is associated with the humidity sensor.

Fig. 13 illustrates a variant of the processing circuitry, wherein separate signal amplifiers 61, 62 are provided for the pressure sensor P and the humidity sensor RH, respectively. The analog outputs of these amplifiers are fed to a multiplexer (MUX) 66, which alternatingly feeds these outputs to a single A/D converter 62. In this manner, only a single DSP 63 is required. This single DSP can be configured to carry out temperature correction of the humidity signal as well as temperature and humidity correction of the pressure signal, as described above.

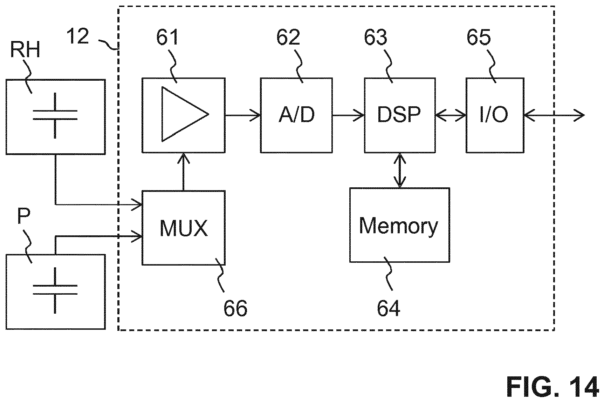

Fig. 14 illustrates yet another variant, wherein a multiplexer 66 is arranged at the input of a single signal amplifier 61. The inputs of the multiplexer are connected to the humidity sensor RH and the pressure sensor P, respectively. This arrangement requires only a single signal amplifier 61. It is particularly suited for embodiments in which the humidity sensor and the pressure sensor have similar capacitances, such as the third embodiment described in conjunction with Fig. 11.

While there are shown and described presently preferred embodiments of the present invention, it is to be understood that the invention is not limited thereto, and that many modifications are possible without leaving the scope of the invention. In particular, the different types of sensors according to the described embodiments can be combined at will on a single substrate. For instance, a pressure sensor as in the first or second embodiment can be combined with a first humidity sensor as in the first or second embodiment plus a second humidity sensor as in the third embodiment to improve reliability of the humidity reading. While the invention has been described in conjunction with a certain layer sequence, the layer sequence may also be different, and different metallization layers than those presently described may be employed for forming the electrodes of the pressure sensor and the humidity sensor.

### LIST OF REFERENCE SIGNS

- 10: sensor sub-assembly
- 11: silicon substrate
- 12: integrated processing circuitry
- 13: layer stack
- 14: via
- 15: separating wall
- 16: contact pad
- 17: contact opening
- 21: second silicon substrate
- 22: buried oxide layer
- 23: silicon device layer
- 24: protective layer
- 25: pressure equalization opening
- 26: pressure equalization opening
- 27: access opening
- 30: pressure sensor
- 31: first pressure sensor electrode
- 32: contact via
- 33: recess
- 34: membrane
- 35: cavity
- 40, 40', 40": humidity sensor
- 41: first humidity sensor electrode
- 42: second humidity sensor electrode
- 43: recess
- 44: membrane
- 45: cavity
- 46: moisture-sensitive dielectric
- 47: upper shielding electrode
- 48: lower shielding electrode
- 49: access opening
- 51: shallow trench
- 52: shallow trench
- 53: pressure equalization channel
- 61, 61': analog signal amplifier
- 62: A/D converter
- 63: digital signal processor
- 64: calibration memory
- 65: I/O interface
- 70: carrier
- 71: carrier substrate
- 72: support portion
- 73: contact portion
- 74: gas-exchange opening
- 75: contact via
- 76: contact pad
- 77: contact pad
- 78: solder ball
- 79: spacer
- 81: bottom side
- 82: top side
- 90: access opening
- 91: arrow

- M1: first metallization layer
- M5: fifth metallization layer
- M6: sixth metallization layer
- M7: seventh metallization layer
- M8: eighth metallization layer
- D1: first dielectric oxide layer
- D6: sixth dielectric oxide layer
- D7: seventh dielectric oxide layer
- P: pressure sensor
- RH: humidity sensor

## Claims

1. A sensor device comprising:
a semiconductor substrate (11)
a layer stack (13) disposed on the first semiconductor substrate (11), the layer stack (13) comprising a sequence of dielectric oxide layers (D1-D7) and metallization layers (M1-M7);
a pressure sensor (30) comprising at least a first pressure sensor electrode (31) that is formed by a portion of one of the metallization layers (M7) in the layer stack;
a humidity sensor (40, 40', 40") comprising at least a first humidity sensor electrode (41) formed by a portion of the same or a different metallization layer (M6, M7) in the layer stack,
**characterised in that** the pressure sensor (30) comprises:
a first recess (33) formed in at least one of the dielectric oxide layers (D7) of the layer stack, wherein the first pressure sensor electrode (31) is disposed in or below the first recess (33);
a deformable first membrane (34) disposed on top of the first recess (33) so as to form a closed first cavity (35), the first membrane (34) forming or carrying a second pressure sensor electrode, deformation of the first membrane (34) causing a capacitance between the first pressure sensor electrode (31) and the second pressure sensor electrode to vary; and
a plurality of vias (14, 32) for connecting the first pressure sensor electrode (31) and the second pressure sensor electrode to integrated or external processing circuitry (12),
and further **characterised in that** the humidity sensor (40, 40', 40") comprises:
a second recess (43) formed in at least one of the dielectric oxide layers (D7) of the layer stack (13) in which the first recess (33) is formed, the second recess (43) being laterally separated from the first recess (33), wherein the first humidity sensor electrode (41) is disposed in or below said second recess (43).

2. The sensor device of claim 1, wherein the humidity sensor (40, 40') further comprises:
a second humidity sensor electrode (42) disposed in said second recess (43), the second humidity sensor electrode (42) being formed by a portion of the same metallization layer (M6, M7) as the one in which the first humidity sensor electrode (41) is formed or being formed by a portion of a different metallization layer (M6, M7), said second humidity sensor electrode (42) being interdigitated with said first humidity sensor electrode (41);
a moisture-sensitive dielectric (44) disposed in the second recess (43) above and/or between the first and second humidity sensor electrodes (41, 42); and
a plurality of vias (14) for connecting the first humidity sensor electrode (41) and the second humidity sensor electrode (42) to integrated or external processing circuitry (12).

3. The sensor device of claim 2,
wherein at least part of the first membrane (34) is formed by a semiconductor layer (23) disposed on top of the layer stack (13), and
wherein the semiconductor layer (23) laterally extends around the humidity sensor (40, 40'), an access opening being provided in said semiconductor layer (23) to provide access to the humidity sensor (40, 40').

4. The sensor device of claim 1, wherein the humidity sensor (40") further comprises:
a second membrane (44) disposed on top of the second recess (43) so as to form a second cavity (45), the second membrane (44) forming or carrying a second humidity sensor electrode;
at least one access opening (49) that enables gas exchange between a top side and a bottom side of the second membrane (44); and
a plurality of vias (14, 32) through the layer stack for connecting the first humidity sensor electrode (41) and the second humidity sensor electrode to integrated or external processing circuitry (12).

5. The sensor device of claim 4, comprising a semiconductor layer (23) disposed on top of the layer stack (13), the semiconductor layer (23) forming at least part of the first membrane (34) and at least part of the second membrane (44).

6. The sensor device of any one of claims 2-5,
wherein the sensor device comprises processing circuitry (12), the processing circuitry (12) preferably being integrated on the semiconductor substrate, in particular, in a CMOS process,
wherein the processing circuitry (12) is configured to measure a first capacitance between the first and second pressure sensor electrodes and to derive, from said first capacitance, an output signal that is indicative of pressure; and
wherein the processing circuitry (12) is further configured to measure a second capacitance between the first and second humidity sensor electrodes and to derive, from said second capacitance, an output signal that is indicative of humidity.

7. The sensor device of claim 6, wherein the processing circuitry is configured to employ the output signal that is indicative of humidity when deriving the output signal that is indicative of pressure.

8. A method of manufacturing a sensor device comprising a pressure sensor (30) and a humidity sensor (40, 40', 40"), the method comprising, not necessarily in this order:
providing a first semiconductor substrate (11);
forming a layer stack (13) on top of the first semiconductor substrate (11), the layer stack (13) comprising a sequence of dielectric oxide layers (D1-D7) and metallization layers (M1-M8);
forming at least one first pressure sensor electrode (31) of the pressure sensor (30) by patterning one of the metallization layers (M7) in the layer stack; and
forming at least a first humidity sensor electrode (41) of the humidity sensor (40, 40', 40") by patterning the same metallization layer (M7) and/or at least one further metallization layer (M6) in the layer stack (13),
**characterised in that** the method further comprises:
forming a first recess (33) in at least one of the dielectric oxide layers (D7) of the layer stack (13) above the first pressure sensor electrode (31);
bonding a semiconductor layer (23) to the layer stack (13) to form a first membrane (34) on top of the first recess (33) so as to form a first cavity (35), the first membrane (34) being deformable by pressure;
forming a plurality of vias (14, 32) through the layer stack (13) for connecting the first pressure sensor electrode (31) and the membrane (34) or a second pressure sensor electrode on the membrane (34) to integrated or external processing circuitry (12); and
forming a second recess (43) in at least one of the dielectric oxide layers (D7) of the layer stack (13) in which the first recess (33) is formed, the second recess (43) being laterally separated from the first recess by at least one portion of said at least one oxide layer (D7), the second recess (43) being arranged above said first humidity sensor electrode (41).

9. The method of claim 8,
wherein at least one first pressure equalization opening (52, 53) is provided for enabling gas exchange between the first cavity (35) and the environment even after the semiconductor layer (23) has been bonded to the layer stack,
wherein annealing is carried out while the first pressure equalization opening (52, 53) is open, and
wherein first pressure equalization opening (52, 53) is subsequently closed to hermetically seal the first cavity (35).

10. The method of claim 8 or 9, further comprising:
providing a second humidity sensor electrode (42) that is interdigitated with said first humidity sensor electrode (41), the second humidity sensor electrode (42) being formed by a portion of the same metallization layer (M6, M7) as the one in which the first humidity sensor electrode (41) is formed or being formed by a portion of a different metallization layer (M6, M7), wherein the second recess (43) is arranged above said first and second humidity sensor electrodes (41, 42);
forming a plurality of vias (14) through the layer stack for connecting the first humidity sensor electrode (41) and the second humidity sensor electrode (42) to integrated or external processing circuitry (12); and
selectively disposing a moisture-sensitive dielectric (46) in the second recess (43) above and/or between the humidity sensor electrodes (41, 42).

11. The method of claim 10,
wherein the second recess (43) is covered by the semiconductor layer (23) when the semiconductor layer (23) is bonded to the layer stack (13) so as to form a second cavity (45),
wherein at least one second pressure equalization opening (51) is provided for enabling gas exchange between the second cavity (45) and the environment even after the semiconductor layer (23) has been bonded to the layer stack (13),
wherein annealing is carried out while the second pressure equalization opening (51) is open, and
wherein the semiconductor layer (23) is subsequently etched to provide an access opening to the second recess (43).

12. The method of claim 10 or 11, further comprising:
mounting a carrier substrate (71) on top of the pressure sensor (30) and the humidity sensor (40, 40', 40"), the carrier substrate (71) having a through opening (90) that provides access to the second recess (43),
wherein the moisture-sensitive dielectric (46) is disposed in the second recess (43) through the through opening (90) after the carrier substrate (71) has been mounted.

13. The method of claim 8 or 9, further comprising:
providing a second membrane (44) on top of the second recess (43) so as to form a second cavity (44), the second membrane (44) being formed by the same semiconductor layer (23) as the one by which the first membrane (34) is formed;
providing at least one access opening (49) to the second cavity (45) to enable gas exchange between the second cavity (45) and the environment; and
forming a plurality of vias (14, 32) through the layer stack (13) for connecting the first humidity sensor electrode (41) and the second membrane (44) or a second humidity sensor electrode on the membrane (44) to integrated or external processing circuitry (12).

## Patentansprüche

1. Eine Sensorvorrichtung, umfassend:
ein Halbleitersubstrat (11)
einen auf dem ersten Halbleitersubstrat (11) angeordneten Schichtstapel (13), wobei der Schichtstapel (13) eine Folge von dielektrischen Oxidschichten (D1-D7) und Metallisierungsschichten (M1-M7) umfasst;
einen Drucksensor (30), der mindestens eine erste Drucksensorelektrode (31) umfasst, die durch einen Anteil einer der Metallisierungsschichten (M7) im Schichtenstapel gebildet ist;
einen Feuchtigkeitssensor (40, 40', 40"), der mindestens eine erste Feuchtigkeitssensorelektrode (41) umfasst, die durch einen Anteil der gleichen oder einer anderen Metallisierungsschicht (M6, M7) im Schichtstapel gebildet wird,
**dadurch gekennzeichnet, dass** der Drucksensor (30) umfasst:
eine erste Aussparung (33), die in mindestens einer der dielektrischen Oxidschichten (D7) des Schichtstapels ausgebildet ist, wobei die erste Drucksensorelektrode (31) in oder unter der ersten Aussparung (33) angeordnet ist;
eine verformbare erste Membran (34), die oben auf der ersten Aussparung (33) angeordnet ist, um einen geschlossenen ersten Hohlraum (35) zu bilden, wobei die erste Membran (34) eine zweite Drucksensorelektrode bildet oder trägt, wobei eine Verformung der ersten Membran (34) eine Veränderung einer Kapazität zwischen der ersten Drucksensorelektrode (31) und der zweiten Drucksensorelektrode verursacht; und
eine Vielzahl von Durchkontaktierungen (14, 32) zum Verbinden der ersten Drucksensorelektrode (31) und der zweiten Drucksensorelektrode mit einer integrierten oder externen Verarbeitungsschaltung (12),
und ferner **dadurch gekennzeichnet, dass** der Feuchtigkeitssensor (40, 40', 40") umfasst:
eine zweite Aussparung (43), die in mindestens einer der dielektrischen Oxidschichten (D7) des Schichtstapels (13) ausgebildet ist, in der die erste Aussparung (33) ausgebildet ist, wobei die zweite Aussparung (43) seitlich von der ersten Aussparung (33) getrennt ist, wobei die erste Feuchtigkeitssensorelektrode (41) in oder unter besagter zweiter Aussparung (43) angeordnet ist.

2. Die Sensorvorrichtung nach Anspruch 1, wobei der Feuchtigkeitssensor (40, 40') ferner umfasst:
eine zweite Feuchtigkeitssensorelektrode (42), die in besagter zweiten Aussparung (43) angeordnet ist, wobei die zweite Feuchtigkeitssensorelektrode (42) durch einen Anteil derselben Metallisierungsschicht (M6, M7) wie diejenige gebildet ist, in der die erste Feuchtigkeitssensorelektrode (41) gebildet ist oder durch einen Anteil einer anderen Metallisierungsschicht (M6, M7) gebildet ist, wobei besagte zweite Feuchtigkeitssensorelektrode (42) mit besagter erster Feuchtigkeitssensorelektrode (41) verzahnt ist;
ein feuchtigkeitsempfindliches Dielektrikum (44), das in der zweiten Aussparung (43) oberhalb und/oder zwischen der ersten und zweiten Feuchtigkeitssensorelektrode (41, 42) angeordnet ist; und
eine Vielzahl von Durchkontaktierungen (14) zum Verbinden der ersten Feuchtigkeitssensorelektrode (41) und der zweiten Feuchtigkeitssensorelektrode (42) mit einer integrierten oder externen Verarbeitungsschaltung (12).

3. Die Sensorvorrichtung nach Anspruch 2,
wobei mindestens ein Teil der ersten Membran (34) durch eine Halbleiterschicht (23) gebildet ist, die oben auf dem Schichtstapel (13) angeordnet ist, und
wobei sich die Halbleiterschicht (23) seitlich um den Feuchtigkeitssensor (40, 40') herum erstreckt, wobei eine Zugangsöffnung in besagter Halbleiterschicht (23) bereitgestellt ist, um Zugang zu dem Feuchtigkeitssensor (40, 40') zu ermöglichen.

4. Die Sensorvorrichtung nach Anspruch 1, wobei der Feuchtigkeitssensor (40") ferner umfasst:
eine zweite Membran (44), die oben auf der zweiten Aussparung (43) angeordnet ist, um einen zweiten Hohlraum (45) zu bilden, wobei die zweite Membran (44) eine zweite Feuchtigkeitssensorelektrode bildet oder trägt;
mindestens eine Zugangsöffnung (49), die einen Gasaustausch zwischen einer Oberseite und einer Unterseite der zweiten Membran (44) ermöglicht; und
eine Vielzahl von Durchkontaktierungen (14, 32) durch den Schichtstapel zum Verbinden der ersten Feuchtigkeitssensorelektrode (41) und der zweiten Feuchtigkeitssensorelektrode mit einer integrierten oder externen Verarbeitungsschaltung (12).

5. Sensorvorrichtung nach Anspruch 4, umfassend eine Halbleiterschicht (23), die oben auf dem Schichtstapel (13) angeordnet ist, wobei die Halbleiterschicht (23) mindestens einen Teil der ersten Membran (34) und mindestens einen Teil der zweiten Membran (44) bildet.

6. Die Sensorvorrichtung nach einem der Ansprüche 2-5,
wobei die Sensorvorrichtung eine Verarbeitungsschaltung (12) umfasst, wobei die Verarbeitungsschaltung (12) vorzugsweise auf dem Halbleitersubstrat integriert ist, insbesondere in einem CMOS-Prozess,
wobei die Verarbeitungsschaltung (12) konfiguriert ist, um eine erste Kapazität zwischen der ersten und der zweiten Drucksensorelektrode zu messen und aus besagter ersten Kapazität ein Ausgangssignal abzuleiten, das auf Druck hindeutet; und
wobei die Verarbeitungsschaltung (12) ferner konfiguriert ist, um eine zweite Kapazität zwischen der ersten und der zweiten Feuchtigkeitssensorelektrode zu messen und aus der besagter zweiten Kapazität ein Ausgangssignal abzuleiten, das auf Feuchtigkeit hindeutet.

7. Sensorvorrichtung nach Anspruch 6, wobei die Verarbeitungsschaltung konfiguriert ist, um das auf Feuchtigkeit hindeutende Ausgangssignal zu verwenden, wenn das auf Druck hindeutende Ausgangssignal abgeleitet wird.

8. Verfahren zur Herstellung einer Sensorvorrichtung, die einen Drucksensor (30) und einen Feuchtigkeitssensor (40, 40', 40") umfasst, wobei das Verfahren - nicht unbedingt in dieser Reihenfolge - umfasst:
Bereitstellen eines ersten Halbleitersubstrats (11);
Bilden eines Schichtstapels (13) oben auf dem ersten Halbleitersubstrat (11), wobei der Schichtstapel (13) eine Folge von dielektrischen Oxidschichten (D1-D7) und Metallisierungsschichten (M1-M8) umfasst;
Bilden mindestens einer ersten Drucksensorelektrode (31) des Drucksensors (30) durch Strukturieren einer der Metallisierungsschichten (M7) im Schichtstapel; und
Bilden mindestens einer ersten Feuchtigkeitssensorelektrode (41) des Feuchtigkeitssensors (40, 40', 40") durch Strukturieren der gleichen Metallisierungsschicht (M7) und/oder mindestens einer weiteren Metallisierungsschicht (M6) im Schichtstapel (13),
**dadurch gekennzeichnet, dass** das Verfahren ferner umfasst:
Bilden einer ersten Aussparung (33) in mindestens einer der dielektrischen Oxidschichten (D7) des Schichtstapels (13) über der ersten Drucksensorelektrode (31);
Verbinden einer Halbleiterschicht (23) mit dem Schichtstapel (13), um eine erste Membran (34) oben auf der ersten Aussparung (33) zu bilden, um einen ersten Hohlraum (35) zu bilden, wobei die erste Membran (34) durch Druck verformbar ist;
Bilden einer Vielzahl von Durchkontaktierungen (14, 32) durch den Schichtstapel (13) zum Verbinden der ersten Drucksensorelektrode (31) und der Membran (34) oder einer zweiten Drucksensorelektrode auf der Membran (34) mit einer integrierten oder externen Verarbeitungsschaltung (12); und
Bilden einer zweiten Aussparung (43) in mindestens einer der dielektrischen Oxidschichten (D7) des Schichtstapels (13), in welcher die erste Aussparung (33) ausgebildet ist, wobei die zweite Aussparung (43) seitlich von der ersten Aussparung durch mindestens einen Anteil besagter mindestens einer Oxidschicht (D7) getrennt ist, wobei die zweite Aussparung (43) oberhalb besagter erster Feuchtigkeitssensorelektrode (41) angeordnet ist.

9. Verfahren nach Anspruch 8,
wobei mindestens eine erste Druckausgleichsöffnung (52, 53) vorgesehen ist, um einen Gasaustausch zwischen dem ersten Hohlraum (35) und der Umgebung auch nach dem Verbinden der Halbleiterschicht (23) mit dem Schichtstapel zu ermöglichen,
wobei ein Glühen durchgeführt wird, während die erste Druckausgleichsöffnung (52, 53) offen ist, und
wobei die erste Druckausgleichsöffnung (52, 53) anschließend geschlossen wird, um den ersten Hohlraum (35) hermetisch abzudichten.

10. Verfahren nach Anspruch 8 oder 9, ferner umfassend:
Bereitstellen einer zweiten Feuchtigkeitssensorelektrode (42), die mit besagter erster Feuchtigkeitssensorelektrode (41) verzahnt ist, wobei die zweite Feuchtigkeitssensorelektrode (42) durch einen Anteil derselben Metallisierungsschicht (M6, M7) wie diejenige gebildet ist, in der die erste Feuchtigkeitssensorelektrode (41) gebildet ist oder durch einen Anteil einer anderen Metallisierungsschicht (M6, M7) gebildet ist, wobei die zweite Aussparung (43) oberhalb besagter erster und zweiter Feuchtigkeitssensorelektrode (41, 42) angeordnet ist;
Bilden einer Vielzahl von Durchkontaktierungen (14) durch den Schichtstapel zum Verbinden der ersten Feuchtigkeitssensorelektrode (41) und der zweiten Feuchtigkeitssensorelektrode (42) mit einer integrierten oder externen Verarbeitungsschaltung (12); und
selektives Anordnen eines feuchtigkeitsempfindlichen Dielektrikums (46) in der zweiten Aussparung (43) oberhalb und/oder zwischen den Feuchtigkeitssensorelektroden (41, 42).

11. Verfahren nach Anspruch 10,
wobei die zweite Aussparung (43) durch die Halbleiterschicht (23) abgedeckt ist, wenn die Halbleiterschicht (23) mit dem Schichtstapel (13) verbunden ist, um einen zweiten Hohlraum (45) zu bilden,
wobei mindestens eine zweite Druckausgleichsöffnung (51) vorgesehen ist, um einen Gasaustausch zwischen dem zweiten Hohlraum (45) und der Umgebung auch nach dem Verbinden der Halbleiterschicht (23) mit dem Schichtstapel (13) zu ermöglichen,
wobei das Glühen durchgeführt wird, während die zweite Druckausgleichsöffnung (51) offen ist, und
wobei die Halbleiterschicht (23) anschließend geätzt wird, um eine Zugangsöffnung zur zweiten Aussparung (43) bereitzustellen.

12. Verfahren nach Anspruch 10 oder 11, ferner umfassend:
Anbringen eines Trägersubstrats (71) oben auf dem Drucksensor (30) und dem Feuchtigkeitssensor (40, 40', 40"), wobei das Trägersubstrat (71) eine Durchgangsöffnung (90) aufweist, die den Zugang zur zweiten Aussparung (43) ermöglicht,
wobei das feuchtigkeitsempfindliche Dielektrikum (46) in der zweiten Aussparung (43) durch die Durchgangsöffnung (90) angeordnet wird, nachdem das Trägersubstrat (71) montiert wurde.

13. Verfahren nach Anspruch 8 oder 9, ferner umfassend:
Bereitstellen einer zweiten Membran (44) oben auf der zweiten Aussparung (43), um einen zweiten Hohlraum (44) zu bilden, wobei die zweite Membran (44) durch dieselbe Halbleiterschicht (23) gebildet ist wie diejenige, durch die die erste Membran (34) gebildet ist;
Bereitstellen mindestens einer Zugangsöffnung (49) zum zweiten Hohlraum (45), um einen Gasaustausch zwischen dem zweiten Hohlraum (45) und der Umgebung zu ermöglichen; und
Bilden einer Vielzahl vom Durchkontaktierungen (14, 32) durch den Schichtstapel (13) zum Verbinden der ersten Feuchtigkeitssensorelektrode (41) und der zweiten Membran (44) oder einer zweiten Feuchtigkeitssensorelektrode auf der Membran (44) mit einer integrierten oder externen Verarbeitungsschaltung (12).

## Revendications

1. Un dispositif capteur comprenant:
un substrat semi-conducteur (11),
un empilement de couches (13) disposé sur le premier substrat semi-conducteur (11), l'empilement de couches (13) comprenant une séquence de couches d'oxyde diélectrique (D1-D7) et de couches de métallisation (M1 -M7);
un capteur de pression (30) comprenant au moins une première électrode de capteur de pression (31) qui est formée par une partie d'une des couches de métallisation (M7) dans l'empilement de couches;
un capteur d'humidité (40, 40 ', 40 ") comprenant au moins une première électrode de capteur d'humidité (41) formée par une partie de la même couche ou d'une couche de métallisation différente (M6, M7) dans l'empilement de couches, **caractérisé en ce que** capteur de pression (30) comprend:
un premier évidement (33) formé dans au moins une des couches d'oxyde diélectrique (D7) de l'empilement de couches, dans lequel la première électrode de capteur de pression (31) est disposée dans ou sous le premier évidement (33);
une première membrane déformable (34) disposée au sommet du premier évidement (33) de manière à former une première cavité fermée (35), la première membrane (34) formant ou portant une deuxième électrode de capteur de pression, une déformation de la première membrane (34) faisant varier une capacité entre la première électrode de capteur de pression (31) et la deuxième électrode de capteur de pression; et
une pluralité de vias (14, 32) pour connecter la première électrode de capteur de pression (31) et la deuxième électrode de capteur de pression à un circuit de traitement intégré ou externe (12), et en outre **caractérisé en ce que** le capteur d'humidité (40, 40', 40 ") comprend:
un deuxième évidement (43) formé dans au moins une des couches d'oxyde diélectrique (D7) de l'empilement de couches (13) dans lequel le premier évidement (33) est formé, le deuxième évidement (43) étant séparé latéralement du premier évidement (33), dans lequel la première électrode de capteur d'humidité (41) est disposée dans ou sous ledit deuxième évidement (43).

2. Le dispositif capteur selon la revendication 1, dans lequel le capteur d'humidité (40, 40') comprend en outre:
une deuxième électrode de capteur d'humidité (42) disposée dans ledit deuxième évidement (43), la deuxième électrode de capteur d'humidité (42) étant formée par une partie de la même couche de métallisation (M6, M7) que celle dans laquelle la première électrode de capteur d'humidité (41) est formée ou étant formée par une partie d'une couche de métallisation différente (M6, M7), ladite deuxième électrode de capteur d'humidité (42) étant interdigitée avec ladite première électrode de capteur d'humidité (41);
un diélectrique sensible à l'humidité (44) disposé dans le deuxième évidement (43) au-dessus et / ou entre les première et deuxième électrodes de capteur d'humidité (41, 42); et
une pluralité de vias (14) pour connecter la première électrode de capteur d'humidité (41) et la deuxième électrode de capteur d'humidité (42) à un circuit de traitement intégré ou externe (12).

3. Le dispositif capteur selon la revendication 2,
dans lequel au moins une partie de la première membrane (34) est formée par une couche semi-conductrice (23) disposée au sommet de l'empilement de couches (13), et
dans lequel la couche semi-conductrice (23) s'étend latéralement autour du capteur d'humidité (40, 40'), une ouverture d'accès étant prévue dans ladite couche semi-conductrice (23) pour permettre l'accès au capteur d'humidité (40, 40').

4. Le dispositif capteur selon la revendication 1, dans lequel le capteur d'humidité (40") comprend en outre:
une deuxième membrane (44) disposée au sommet du deuxième évidement (43) de manière à former une deuxième cavité (45), la deuxième membrane (44) formant ou portant une deuxième électrode de capteur d'humidité;
au moins une ouverture d'accès (49) permettant un échange de gaz entre un côté supérieur et un côté inférieur de la deuxième membrane (44); et
une pluralité de vias (14, 32) traversant l'empilement de couches pour connecter la première électrode de capteur d'humidité (41) et la deuxième électrode de capteur d'humidité à un circuit de traitement intégré ou externe (12).

5. Le dispositif capteur selon la revendication 4, comprenant une couche semi-conductrice (23) disposée au sommet de l'empilement de couches (13), la couche semi-conductrice (23) formant au moins une partie de la première membrane (34) et au moins une partie de la deuxième membrane (44).

6. Le dispositif capteur selon l'une quelconque des revendications 2 à 5,
dans lequel le dispositif capteur comprend un circuit de traitement (12), le circuit de traitement (12) étant de préférence intégré sur le substrat semi-conducteur, en particulier dans un processus CMOS,
dans lequel le circuit de traitement (12) est configuré pour mesurer une première capacité entre les première et deuxième électrodes de capteur de pression et pour dériver, à partir de ladite première capacité, un signal de sortie qui est indicatif de la pression; et
dans lequel le circuit de traitement (12) est en outre configuré pour mesurer une deuxième capacité entre les première et deuxième électrodes de capteur d'humidité et pour dériver, à partir de ladite deuxième capacité, un signal de sortie qui est indicatif de l'humidité.

7. Le dispositif capteur selon la revendication 6, dans lequel le circuit de traitement est configuré pour utiliser le signal de sortie qui est indicatif de l'humidité lorsqu'il dérive le signal de sortie qui est indicatif de la pression.

8. Un procédé de fabrication d'un dispositif capteur comprenant un capteur de pression (30) et un capteur d'humidité (40, 40', 40"), le procédé comprenant, non nécessairement dans cet ordre:
fournir un premier substrat semi-conducteur (11);
former une couche un empilement (13) au sommet du premier substrat semi-conducteur (11), l'empilement de couches (13) comprenant une séquence de couches d'oxyde diélectrique (D1-D7) et de couches de métallisation (M1-M8);
former au moins une première électrode de capteur de pression (31) du capteur de pression (30) en structurant une des couches de métallisation (M7) dans l'empilement de couches; et
former au moins une première électrode de capteur d'humidité (41) du capteur d'humidité (40, 40', 40") en configurant la même couche de métallisation (M7) et / ou au moins une autre couche de métallisation (M6) dans l'empilement de couches (13),
**caractérisé en ce que** le procédé comprend en outre:
former un premier évidement (33) dans au moins une des couches d'oxyde diélectrique (D7) de l'empilement de couches (13) au-dessus de la première électrode de capteur de pression (31);
lier une couche semi-conductrice (23) à l'empilement de couches (13) pour former une première membrane (34) au sommet du premier évidement (33) de manière à former une première cavité (35), la première membrane (34) pouvant être déformée par pression;
former une pluralité de vias (14, 32) à travers l'empilement de couches (13) pour connecter la première électrode de capteur de pression (31) et la membrane (34) ou une deuxième électrode de capteur de pression sur la membrane (34) à un circuit de traitement intégré ou externe.

9. Le procédé selon la revendication 8,
dans lequel au moins une première ouverture d'égalisation de pression (52, 53) est prévue pour permettre un échange de gaz entre la première cavité (35) et l'environnement, même après le collage de la couche semi-conductrice (23) à l'empilement de couches,
dans lequel un recuit est effectué alors que la première ouverture d'égalisation de pression (52, 53) est ouverte, et
dans lequel la première ouverture d'égalisation de pression (52, 53) est ensuite fermée pour sceller la première cavité (35) de manière hermétique.

10. Le procédé selon la revendication 8 ou 9, comprenant en outre:
fournir une deuxième électrode de capteur d'humidité (42) qui est interdigitée avec ladite première électrode de capteur d'humidité (41), la deuxième électrode de capteur d'humidité (42) étant formée par une partie de la même couche de métallisation (M6, M7) que celle dans laquelle la première électrode de capteur d'humidité (41) est formée ou étant formée par une partie d'une couche de métallisation différente (M6, M7), dans lequel le deuxième évidement (43) est disposé au-dessus desdites première et deuxième électrodes de capteur d'humidité (41, 42);
former une pluralité de vias (14) traversant l'empilement de couches pour connecter la première électrode de capteur d'humidité (41) et la deuxième électrode de capteur d'humidité (42) à un circuit de traitement intégré ou externe (12); et
disposer sélectivement un diélectrique sensible à l'humidité (46) dans le deuxième évidement (43) au-dessus et / ou entre les électrodes de capteur d'humidité (41, 42).

11. Le procédé selon la revendication 10,
dans lequel le deuxième évidement (43) est recouvert par la couche semi-conductrice (23) lorsque la couche semi-conductrice (23) est liée à l'empilement de couches (13) de manière à former une deuxième cavité (45),
dans lequel au moins une deuxième ouverture d'égalisation de pression (51) est prévue pour permettre un échange de gaz entre la deuxième cavité (45) et l'environnement, même après le collage de la couche semi-conductrice (23) à l'empilement de couches (13),
dans lequel un recuit est effectué alors que la deuxième ouverture d'égalisation de pression (51) est ouverte, et
dans lequel la couche semi-conductrice (23) est gravée ultérieurement pour fournir une ouverture d'accès au deuxième évidement (43).

12. Le procédé selon la revendication 10 ou 11, comprenant en outre:
monter d'un substrat porteur (71) au sommet du capteur de pression (30) et du capteur d'humidité (40, 40', 40"), le substrat porteur (71) ayant une ouverture traversante (90) donnant accès au deuxième évidement (43),
dans lequel le diélectrique sensible à l'humidité (46) est disposé dans le deuxième évidement (43) à travers l'ouverture traversante (90) après le montage du substrat de support (71) .

13. Le procédé selon la revendication 8 ou 9, comprenant en outre:
fournir une deuxième membrane (44) au sommet du deuxième évidement (43) de manière à former une deuxième cavité (44), la deuxième membrane (44) étant formée par la même couche semi-conductrice (23) que celle par laquelle la première membrane (34) est formée;
fournir au moins une ouverture d'accès (49) à la deuxième cavité (45) pour permettre un échange de gaz entre la deuxième cavité (45) et l'environnement; et
former une pluralité de vias (14, 32) traversant l'empilement de couches (13) pour connecter la première électrode de capteur d'humidité (41) et la deuxième membrane (44) ou une deuxième électrode de capteur d'humidité sur la membrane (44) à un circuit de traitement intégré ou externe (12).
